# EUROPEAN PATENT APPLICATION

(11) **EP 4 439 885 A1**
(43) Date of publication of application: **02.10.2024**
(21) Application number: 24020096.4
(22) Date of filing: 31.03.2024
(51) Int. Cl.: H02G 1/02

(54) **ROBOT FOR DISPLACEMENT THROUGH MEDIUM AND HIGH VOLTAGE ELECTRICAL LINES**

(30) Priority: 31.03.2023 ES 202330272
(71) Applicant: López Alonso, Jesús, 32001 Ourense (ES)
(72) Inventor: López Alonso, Jesús, 32001 Ourense (ES)
(74) Representative: De Castro Hermida, José Luis

(57) **Abstract**

The robot for moving along medium and high voltage power lines is capable of moving along the line and avoiding most of the switchgear, collecting all the data and images necessary to study its current status and predict possible incidents in order to carry out corrective and preventive maintenance before it affects the continuity of supply. The robot is ideal for reporting the status of the installation, reducing the time and resources used in the inspection while increasing the number of daily kilometers analyzed.

## Description

### TECHNICAL FIELD

ELECTRICAL SECTOR: in this sector, currently a large amount of human resources is being allocated to grid inspection and maintenance tasks, which represents a large amount of economic resources. These inspections are being performed mostly on foot, which makes them slow, in some cases they are being made with helicopters, which makes them very expensive and are currently being made with drones, which makes them dangerous. Since it is a strategic sector that is increasingly indispensable in the everyday life of citizens and its work activity implies large and serious risks, it deserves a technological innovation that allows work to be performed by minimizing risks and optimizing inspection and preventive maintenance operations that guarantee supply.

### BACKGROUND OF THE INVENTION

Once tested on the Internet and in the Patent and Trademark Office, some approaches are found that in some cases are far apart from addressing the three larger problems faced by this type of apparatus, which are: the presence of very high voltages and non-negligible intensities, the strong magnetic fields to which the apparatus working under these conditions are subjected and the challenge of moving along the line advancing from one span of the conductor to another, which is delimited by the supports, and the passage of the various elements of the complex switchgear of the power lines.

There is a self-propelled vehicle covered by patent ES 2 575 737 A1, which moves along the high voltage lines by an additional cable which is installed in the line and that further has no voltage, which complicates its installation.

There is also an autonomous inspection system with patent ES 1 152 085 U, which is still an intent statement, without taking into account the three main problems that present the power lines, in addition to not having a mechanical design that carries out the movement and avoids the obstacles of the grid.

A system for inspection of power lines was patented from Peru under the number PCT/PE2017/000033, this system is intended to transition over the conductors and pass the elements of the line, something which is impossible and the proof is that it does not have a suitable mechanical design nor it is explained how to pass the electrical switchgear.

In the US there is a device such as "Expliner" that moves along two conductors of the same circuit, it is cumbersome and bulky, in addition to requiring two conductors for its movement.

Also, in the US there is the "SkySweeper" which is a robot project that moves through jumps and that is not developed to run along a live line, these jumps produce vibrations in the conductors, which can cause breakdowns due to short-circuits in the grid.

This invention that is exposed represents a large innovation in providing a solution to such a complicated aspect with a simple, light robot that is capable of moving at relatively high speeds in an agile manner along medium and high voltage lines, without installation problems.

### EXPLANATION OF THE INVENTION

Initially this robot is intended for inspection tasks, with autonomous capacity, it is programmable with the grid structure (although it could detect it by itself). It will be able to move autonomously and take the data and images to be transmitted to a SCADA (Supervisory Control and Data Acquisition) system housed remotely which will process and analyze data to send new commands or requests to the robot, when appropriate. The robot circulates suspended from the line and by the bottom of the conductor.

This same robot can be provided with articulated arms with the appropriate claws for repair and maintenance tasks. The solutions to the three groups of major problems presented by actuations in a live electrical grid are basically described below, which are described in the four sections:
1- Isolation of the voltages and intensities present in the conductor, as it is an apparatus clamped to a single cable, it works at potential and avoids touching other parts or elements of the line that are not at the same voltage, as well as objects foreign to the line close thereto, this way we avoid having potential differences. That is why it only needs a certain degree of insulation so that dangerous voltages and intensities do not occur between the two clamping clips of the robot, which do not affect the electronics. Nothing that cannot be addressed with external polymeric insulation similar to that of insulators. Taking into account that most cables are made of aluminum and its electrical resistance is 3,2110⁻⁸ Ωm, being a relatively small distance, the resistance will not reach in any case high values, they can be between 6,4220⁻⁸ Ω and 9,630⁻⁸ Ω in a first estimate. Thus, if we have practically no potential differences and the resistances are small, the intensities are also negligible. In addition, its "V" shape moves the sensitive parts sufficiently away so that electric shocks do not occur.
2- Regarding the induction considering that the electronics of the apparatus is housed inside, to avoid possible adverse effects of this, the robot will be provided of a metallic shielding between the external insulation and another one internal, which isolates the casing mechanically protecting all the robot's electronics.

Attached to each clip and at the bottom all the components, mechanisms and electronics will be housed, within what is hereinafter referred to as supervisor; cameras (optical, infrared), distance detectors (ultrasonic and laser), as well as motors or servomotors for its operation, a controller for all the necessary electronics like an Arduino and a minicomputer, for example raspberry pi, to carry out the assigned automation and communication tasks, using the appropriate software connected to the SCADA system (what is provided as an example is what was initially used but due to the needs of the final design it may be varied).

The robot's protection layers will be: electrical, inductive, and mechanical; the layers are the same throughout the apparatus and are composed of an outer polymeric insulation, a metallic shielding, a semiconductive layer, another inner insulation, and a mechanical protection casing.

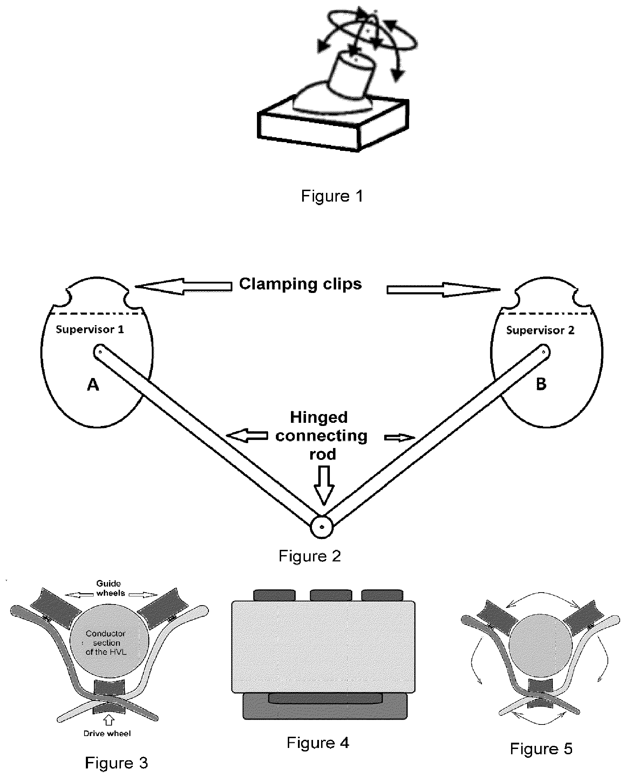

3.2- The top of both supervisors will be formed by the clip which will be responsible for clamping to the cable and providing linear movement to the robot. This clip will be something similar to a "V" with oval walls. At the top of the clip there will be at least three bearings which will serve as a guide and support. On the bottom it will have a drive wheel, which will provide enough traction to move the robot, the walls of the "V" will be joined with a joint which allows the opening and closing movement to clamp and release the cable. As an additional safety measure, it will have a lock, which is not shown in the drawing, which ensures the closing and prevents accidental detachment. The approximate appearance of the clip will be that of the herein accompanying drawing, Figures 3, 4 and 5.

4- Explanation of the process of jumping over obstacles, normal movement along the cable is guided by the sensors available on the robot. These detect the distance to nearby objects and that with artificial intelligence software (Al), once trained by machine learning, the type of object is distinguished and if they are foreign or belong to the line, analyzing if it is necessary to go back or they can be passed to continue its travel. In any case, it will reduce speed and stop, identifying the type of obstacle before starting the maneuver.

By way of example, the steps for operation of the passage of a tether support are indicated. If we call the Supervisor 1 "A" and the Supervisor 2, "B", and we understand that the robot is traveling in the "A→B" direction. The "B" part close to the first tethering clip is separated from the conductor and moved downward, at the same time that it is drawn forward, the part "A" moves slightly forward as well, then the part "B" will rise and connect to the conductor once the first clip is passed, then the part "A" will be detached from the conductor and will go down while the part "B" moves forward (if necessary), the part is then raised again and clamped to the conductor between the two clips, a similar motion is then performed with the next clip until it can be matched after the support and continuing with normal travel along the conductor.

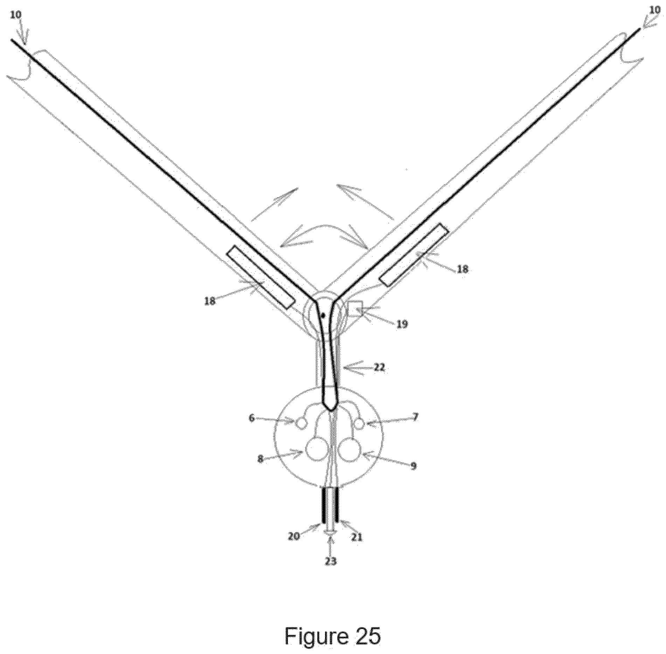

For higher voltage lines, wherein induction and arc effect are greater, a small modification of the design may be necessary to avoid problems of both electrical and magnetic isolation. In that case the distance sensors and chambers of the two supervisors would be displaced to a sphere located at the apex of the connecting rods, which is depicted in Figure 25, the result will be a greater insulation of the apparatus.

Placement on the line can be made by manual means by means of an insulated maneuvering pole, which holds the robot by the apex of the connecting rods, in the inverted position and once clamped to the lines, it is rotated 180° to remain in its normal operating position. It may also be coupled, by a drone that raises it with two "Y"-shaped arms that hold it by the connecting rods of the supervisors near them.

Identification of the robot components, both of the two supervisors (main modules) and of the connecting rod therefrom.
- 1: Motor for the clip safety lock
- 2: Motor for the opening and closing movement of the clip [this is duplicated for safety]
- 3: Motor of the drive wheel
- 4: Motor for the vertical movement of the conical motion ball joint
- 5: Motor for the horizontal movement of the conical motion ball joint
- 6: Ultrasonic [or laser] distance detector
- 7: Laser distance detector
- 8: Optical camera
- 9: Thermal chamber
- 10: Data bus, command bus, and system power supply
- 11: Electronic components controller
- 12: System processor
- 13: GPS controller
- 14: Memory unit
- 15: Communication module
- 16: System power module and battery charger
- 17: Coils for induction charging the system
- 18: Battery
- 19: Motor for the angular movement of the connecting rods
- 20: GPS antenna
- 21: Communication antenna
- 22: Insulator, protection, and output of the antennas
- 23: Chamber 360

### BRIEF DESCRIPTION OF THE DRAWINGS

Piece with conical movement Figure 1 placed between the supervisors and the rod.

The schematic representation of the robot is Figure 2.

The fastening clips Figures 3, 4 and 5.

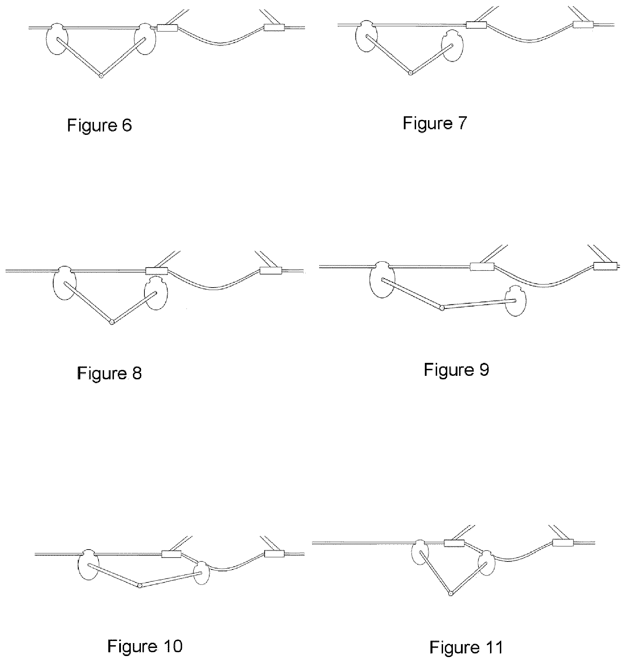

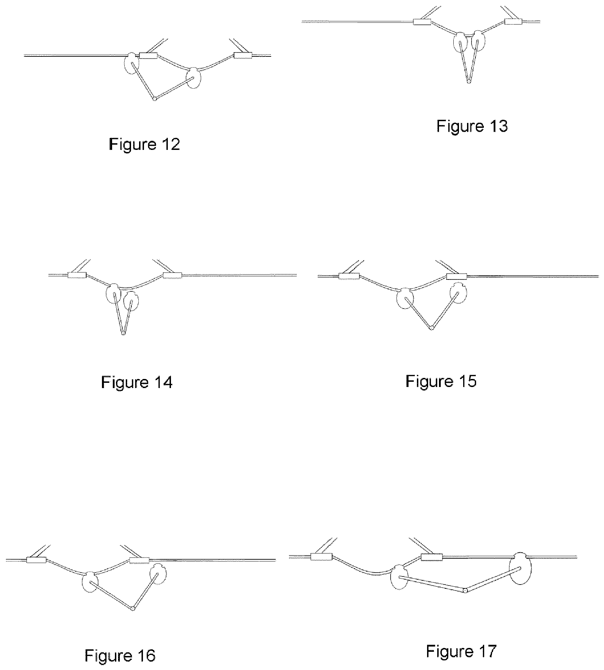

Movement passage of a support with two tethering clips, in the sequence of figures between Figure 6 to Figure 21.

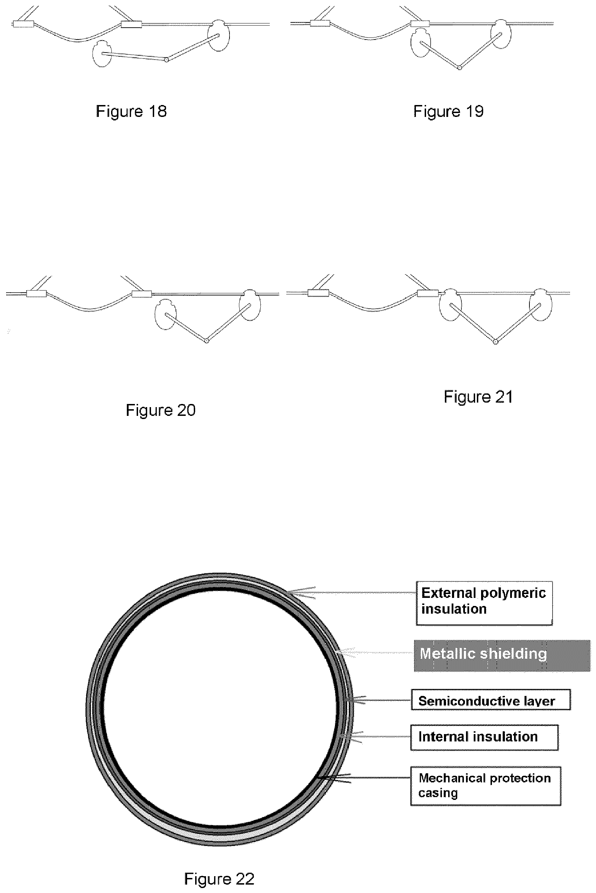

In Figure 22 is represented the section of the connecting rod indicating the protection layers.

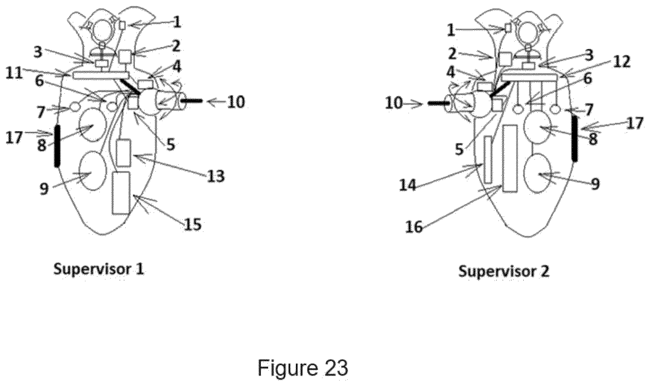

Exploded view of the two supervisors of the robot Figure 23.

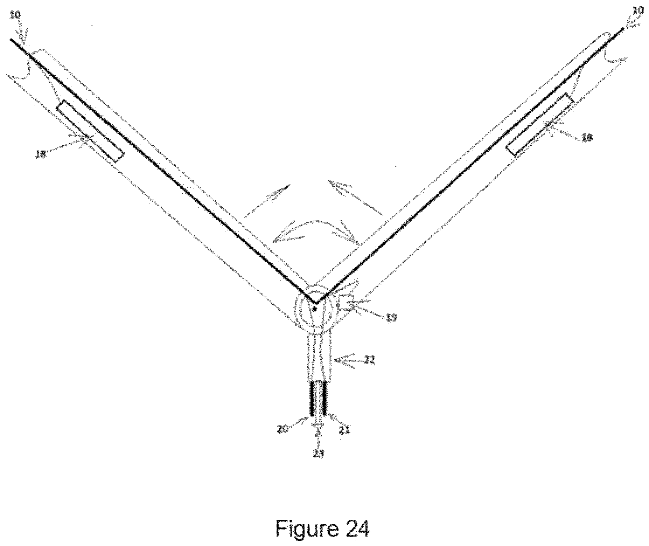

The connecting rod of the main modules Figures 24 and 25.

### PREFERRED EMBODIMENT OF THE INVENTION

In view of the aforementioned figures, and according to the adopted numbering, a preferred embodiment of the invention can be seen therein, which comprises the parts and elements indicated and described in detail below.

In Figure 2 the robot can be seen, composed of the two supervisors, on the top are the clips, Figures 3 to 5, which are responsible for clamping the robot to the line and movement therethrough, below are the two supervisors of the robot in which the electronics and mechanical elements that can be seen in Figure 23 which are essentially the following are distributed:
- a motor (1), which moves a safety lock of the clip.
- two motors (2), which open and close the clip to be clamped to the conductor.
- a motor, which moves the wheel that is in contact with the conductor (3) and produces movement of the equipment along the line.
- a motor (4), which gives the connecting piece between the supervisor and the connecting rod the vertical movement.
- a motor (5), which gives the connecting piece between the supervisor and the connecting rod the horizontal movement.
- an ultrasound or laser distance detector (6), which prevents the robot from colliding with any element foreign to the line close thereto.
- a laser distance detector (7), which prevents the robot from colliding with any element belonging to the line lying on its way.
- an optical chamber (8), which collects the line status images and all of its components, supports, isolating crossbars as well as the environment within the line protection zone.
- a thermal chamber (9), which captures the status of the elements subjected to current and its isolation, for detecting hot spots that can cause an anomaly in the supply.
- the electronics wiring (10), which connects the processor and the control unit with all electronic elements of the robot.
- a controller (11), which coordinates all of the motors, sensors, and communicates with the central unit.
- a central unit (12), which processes all data collected by the robot, processes them and gives the commands to the controller for proper operation, in addition to communicating with the exterior positioning the images with the GPS (13) and sending them to the internal memory (14) or the central system for important analysis in need of greater calculation potential, this operation is performed through the communication module (15) and the antenna (21).
- a coil (17) will be installed which, taking advantage of the induction of the line, will charge the batteries (18) that power the system, in parallel with the charger located in the power module (16).
- a motor (19), which will provide angular movement to the connecting rods of the two supervisors of the robot.
- an insulator (22) conveniently placed at the furthest end of the line to allow for the output of the antennas (20 and 21) as well as a camera 360 (23) that will provide the images to collect the line protection space.

The connecting rod of the two modules, Figures 24 and 25, which further are the two arms that together with the connecting ball joint, like a wrist, the supervisors like a hand and the clip like fingers make up the robot, with capacity of movement through the switchgear of the power lines.

Finally, this invention can be applied to the inspection tasks of medium and high voltage lines, providing a large amount of data to determine the status and predict possible anomalies that can disturb the normal operation thereof. All this in record time with a lower cost than the current one and with greater safety for the operators in charge of this work.

## Claims

1. Robot for moving along medium and high voltage lines, and which can avoid the elements that make up the structure of the line, **characterized in that** it comprises two supervisors at the top joined together by articulated arms formed by connecting rods with a connecting ball joint, giving the robot a "V" shape, wherein each supervisor comprises
a clamping clip comprising at least three guide and support bearings at the top and a drive wheel at the bottom for the movement of the robot,
internally at least comprises one motor (1) that moves a safety lock of the clamp; two motors (2) that open and close the clip for clamping to the conductor; a motor that moves the wheel that is in contact with the conductor (3) and produces the movement of the equipment along the line; a motor (4) that gives the connecting piece between the supervisor and the connecting rod the vertical movement; a motor (5) that gives the connecting piece between the supervisor and the connecting rod the horizontal movement;
a power supply module (16) of the system.
an ultrasonic or laser distance detector (6) for detecting any element foreign to the line close to the robot;
a laser distance detector (7) for detecting any element belonging to the line in the robot's way;
an optical camera (8) for collecting images of the line status;
a thermal camera (9) for detecting hot spots that may cause anomalies in the supply;
a GPS (13), a communication module (15) and an antenna (21);
an electronics wiring (10) connecting a controller and a control unit with all the electronic elements of the robot;
a controller (11) coordinating all the motors, sensors and communicating them with the central unit;
a central unit (12) processing and sending all the data collected by the robot;
and wherein each connecting rod comprises a motor (19) providing angular movement to the connecting rods and a battery (18), being in connection with the electronics wiring (10).

2. Robot for moving along medium and high voltage lines, according to claim 1, **characterized in that** each supervisor comprises a coil (17) which, taking advantage of the induction of the line, charges the batteries (18) of the rods and a charger located in the power supply module (16).

3. Robot for moving along medium and high voltage lines, according to claim 1, **characterized in that** the central unit (12) comprises an internal memory unit (14).

4. Robot for moving along medium and high voltage lines, according to claim 1, **characterized in that** it comprises an insulator (22) at the end of the arms or connecting ball joint, wherefrom antennas (20 and 21) and a 360° camera (23) emerge to collect the line protection space.

5. Robot for moving along medium and high voltage lines, according to the preceding claims, **characterized in that** the ultrasonic or laser distance detector (6); the laser distance detector (7); the optical camera (8); and the thermal camera (9) are arranged in a sphere located at the apex of the connecting rods or connecting ball joint and which is in contact with the insulator (22).
